**Europäisches Patentamt**

**European Patent Office**

**Office européen des brevets**

(11) Veröffentlichungsnummer: **0 203 208**

**B1**

(12) **EUROPÄISCHE PATENTSCHRIFT**

(45) Veröffentlichungstag der Patentschrift:
**23.11.88**

(21) Anmeldenummer: **85106351.1**

(22) Anmeldetag: **23.05.85**

(51) Int. Cl.⁴: **H 03 L 7/18**

(54) Frequenzsyntheseschaltung zur Erzeugung eines analogen Signals mit digital in Stufen einstellbarer Frequenz.

(43) Veröffentlichungstag der Anmeldung:
**03.12.86 Patentblatt 86/49**

(45) Bekanntmachung des Hinweises auf die Patenterteilung:
**23.11.88 Patentblatt 88/47**

(84) Benannte Vertragsstaaten:
**DE FR NL**

(56) Entgegenhaltungen:
**US-A-3 555 446**
**US-A-3 582 810**
**US-A-3 913 028**
**US-A-4 052 673**

(73) Patentinhaber: **Deutsche ITT Industries GmbH,**
**Hans- Bunte- Strasse 19 Postfach 840, D-7800**
**Freiburg (DE)**

(72) Erfinder: **Mehrgardt, Sönke, Dr., Häglestrasse 26,**
**D-7801 March (DE)**

(74) Vertreter: **Morstadt, Volker, Dipl.- Ing., c/o**
**Deutsche ITT Industries GmbH**
**Patent/Lizenzabteilung Postfach 840 Hans- Bunte-**
**Strasse 19, D-7800 Freiburg/Brsg. (DE)**

## Beschreibung

Die Erfindung betrifft eine Frequenzsyntheseschaltung zur Erzeugung eines analogen Signals mit digital in Stufen einstellbarer Frequenz, bei der ein ein Referenzsignal erzeugender Referenzoszillator, ein Phasenvergleicher, ein analoger Tiefpaß und ein spannungsgesteuerter Oszillator (= VCO) in dieser Reihenfolge signalflußmäßig in Serie geschaltet sind und bei der der Phasenvergleicher vom VCO angesteuert ist. Der Phasenvergleicher ist dabei eine mit Digitalsignalen gespeiste Digitalschaltung, wobei der eine Eingang mit dem Ausgang eines digitalen Akkumulators verbunden ist. Dessem Eingang ist ein Zahlenwert zugeführt, der die Frequenz des analogen Signals bestimmt, vgl. den jeweiligen Oberbegriff der Ansprüche 1 und 2.

Eine derartige Frequenzsyntheseschaltung mit einer Phasenregelschleife ist in US-A-3 582 810 beschrieben. Sie enthält einen Referenzoszillator zur Erzeugung eines Taktsignals, das u.a. dem Takteingang des Phasenvergleichers und dem des digitalen Akkumulators zugeführt ist. Das Ausgangssignal des Phasenvergleichers wird mittels einer Strom-Summierschaltung in ein Analogsignal gewandelt. Nach einer Tiefpaßfilterung gelangt es als Steuersignal an den VCO. Dessen analoges Ausgangssignal ist das zu erzeugende analoge Signal, das ferner dem Zähleingang eines dreistufigen binären Zählers zugeführt ist. Der jeweilige Zählerstand liegt als Datensignal am zweiten Eingang des digitalen Phasenvergleichers, dessen erster Eingang, wie beschrieben, mit dem Akkumulatorausgang verbunden ist.

In US-A-3 555 446 ist ferner eine sehr ähnliche Frequenzsyntheseschaltung beschrieben, die ebenfalls eine aus digitalen und analogen Teilen bestehende Phasenregelschleife enthält. Dem digitalen Phasenvergleicher sind als Eingangssignale wieder der Inhalt eines mit dem VCO verbundenen Zählers und der Inhalt eines digitalen Akkumulators zugeführt.

Frequenzsyntheseschaltungen in Form von Phasenregelschleifen sind weit verbreitet und beschrieben, vgl. z. B. R. Best "Theorie und Anwendungen des Phase-locked-loops", AT-Verlag, Stuttgart, 3. Auflage, 1982, Seiten 85 bis 89, insbesondere Bild 79b. Mit dieser Frequenzsyntheseschaltung wird ein Signal erzeugt, das in einem festen, aber digital einstellbaren Frequenzverhältnis zu einer Referenzfrequenz steht. Dies wird durch einen einstellbaren Frequenzteiler erreicht, der in den Rückkopplungsweg zwischen den VCO-Ausgang und den Phasenvergleicher geschaltet ist.

Der Hauptnachteil bei den letztbeschriebenen Frequenzsyntheseschaltungen ist die Schwierigkeit, die Frequenz in kleinen Schrittweiten einzustellen, insbesondere wenn das Frequenzverhältnis von Schwingungsfrequenz des VCO zu Referenzfrequenz etwa zwischen 0,1 und 10 liegt. Die Verwendung von Frequenzteilern mit nichtganzzahligen Teilungzahlen behebt zwar diese Schwierigkeit, allerdings ist dies mit Phasenzittern erkauft.

Der in den Ansprüchen gekennzeichneten Erfindung liegt daher die Aufgabe zugrunde, die bekannte Frequenzsyntheseschaltung so weiterzubilden, daß die Referenzfrequenz möglichst dicht an die VCO-Frequenz herangeführt werden und die Schrittweite der Frequenzeinstellung sehr klein im Verhältnis zur VCO-Frequenz sein kann, daß ferner die Signalfrequenz quarzgenau und in einem weiten Frequenzbereich einstellbar ist und daß schließlich die Frequenzsyntheseschaltung einfach integrierbar ist und in Frequenzsynthesesystemen von Rundfunk-, Fernseh- und Phonogeräten verwendet werden kann.

Die Erfindung wird nun anhand der Figuren der Zeichnung näher erläutert:

Fig. 1 zeigt in Form eines Blockschaltbilds schematisch ein Ausführungsbeispie1 der ersten Lösungsvariante der Erfindung,

Fig. 2 zeigt das Blockschaltbild einer Ausführungsform der zweiten Lösungsvariante der Erfindung, und

Fig. 3 zeigt das Blockschaltbild einer Ausführungsform der als Ring geschalteten laufzeitgesteuerten Verzögerungsleitung.

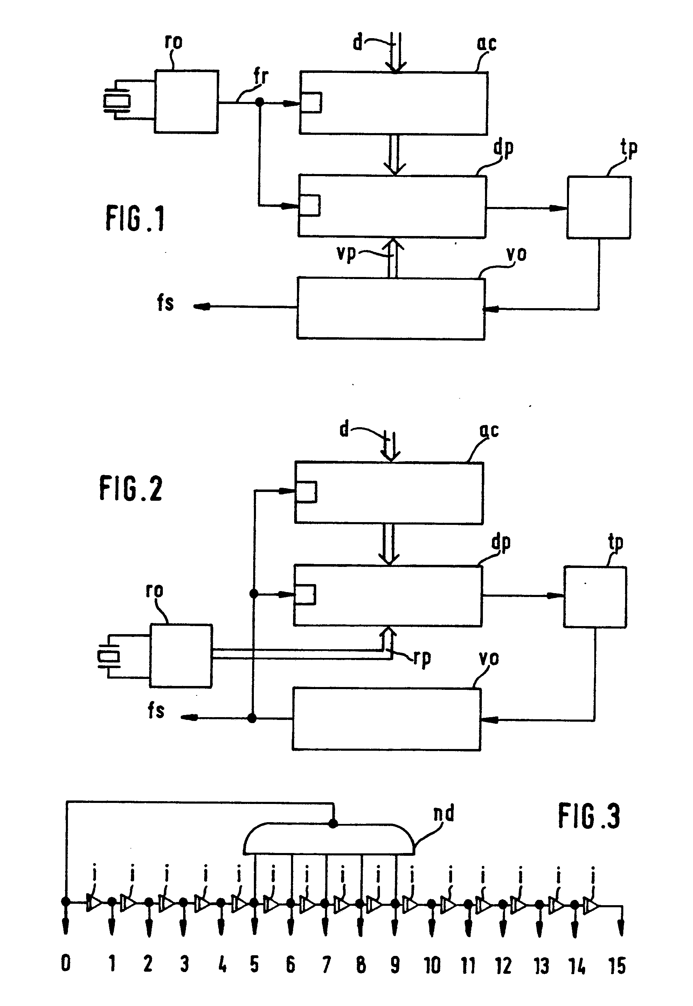

Im Blockschaltbild nach Fig. 1 speist der quarzstabilisierte Referenzoszillator ro mit seinem Ausgangssignal, dem Referenzsignal fr, den jeweiligen Takteingang des Akkumulators ac und des Phasenvergleichers dp. Dem Akkumulator ac ist an seinem Dateneingang der die Frequenz bestimmende Zahlenwert d zugeführt. Das Ausgangssignal des Akkumulators ac ist dem ersten Eingang des digitalen Phasenvergleichers dp zugeführt. Dessen digitales, z. B. binäres Ausgangssignal speist den Eingang des analogen Tiefpasses tp, dessen Ausgang mit dem Steuereingang des VCO vo verbunden ist. Dieser speist mit seinem der Phase entsprechenden Datensignal vp den zweiten Eingang des Phasenvergleichers dp. Das Ausgangssignal des VCO ist das kontinuierliche Signal fs, das weiteren Schaltungsteilen zugeführt ist.

Im Blockschaltbild nach Fig. 2 ist das Ausgangssignal des VCO vo, das Signal fs, weiteren Schaltungsteilen und dem jeweiligen Takteingang von Akkumulator ac und digitalem Phasenvergleicher dp zugeführt. Der Dateneingang des Akkumulators ac ist mit dem Zahlenwert d gespeist, und der Ausgang des Akkumulators ac ist mit dem ersten Eingang des digitalen Phasenvergleichers dp verbunden. Dessen zweiter Eingang ist mit dem der Phase des quarzgesteuerten Referenzoszillators ro entsprechenden Digitalsignal, der Referenzphase rp, gespeist. Das digitale z. B. binäre Ausgangssignal des digitalen Phasenvergleichers dp ist dem analogen Tiefpaß tp zugeführt, dessen Ausgangssignal zum Steuereingang des VCO vo gelangt.

Im Blockschaltbild nach Fig. 3 ist eine Kette von 15 nichtinvertierenden Verzögerungsgliedern, die jeweils aus einem Doppelinverter i bestehen, schematisch gezeigt, wobei der Eingang jedes nachfolgenden Doppelinverters mit dem Ausgang des vorangehenden Doppelinverters verbunden ist und diese Verbindungen als Spannungsabgriffe nach außen geführt sind. zusätzlich zu diesen Spannungsabgriffen ist der Eingang des ersten der Doppelinverter i und der Ausgang des letzten der Doppelinverter i ebenfalls nach außen geführt. Die Spannungsabgriffe sind vom Eingang her mit 0 bis 15 durchnumeriert. Jeweils ein Eingang des NAND-Gatters nd mit fünf Eingängen ist mit dem Abgriff 5 bzw. 6 bzw. 7 bzw. 8 bzw. 9 verbunden, und der Ausgang des NAND-Gatters nd speist den Eingang des ersten Doppelinverters.

Die Lösung der gestellten Aufgabe wird bei der Erfindung im wesentlichen dadurch erreicht, daß die Phasenregelschleife durch den Akkumulator ac ergänzt ist, der vom Referenzsignal oder vom VCO-Signal getaktet wird und mit jedem Taktimpuls einen an seinen Dateneingang angelegten Zahlenwert d akkumuliert, d.h. zum Ergebnis der vorausgehenden Akkumulation addiert. Dr jeweilige Akkuinhalt dient dabei als konstant zunehmende Phase eines digitalen Oszillators. Diese Phase wird im digitalen Phasenvergleicher dp mit der digital codierten Phase des Referenzoszillators ro oder des VCO vo verglichen. Je nach voraus- oder nacheilender Phase gibt der Phasenvergleicher dp ein digitales, z. B. binäres Steuersignal ab, das mit dem analogen Tiefpaß tp geglättet wird und den analogen Steuerungseingang des VCO vo speist.

Die digital codierte Phase des Referenzoszillators oder des VCO kann vorteilhaft dadurch erzeugt werden, daß der Referenzoszillator einen steuerbaren Verzögerer mit zeitlich äquidistanten Abgriffen oder eine laufzeitgesteuerte Verzögerungsleitung enthält, deren Verzögerungsglieder mit Signalabgriffen versehen sind. Der momentane Zustand dieser Signalabgriffe stellt die momentane Phase des Referenzoszillators ro oder des VCO vo dar.

Der steuerbare Verzögerer kann z. B. einen Kondensator enthalten, der mittels eines steuerbaren Stroms umgeladen wird. Spannungsvergleicher entlang der Umladestrecke ergeben die zeitlich äquidistanten Abgriffe. Die Umladedauer ist entweder mit der Referenzperiode oder mit der VCO-Periode synchronisiert. Die Synchronisation kann vorteilhafterweise entfallen, wenn die Umladestrecke wie bei Relaxationsoszillatoren gleichzeitig zeitbestimmende Größe des VCO vo ist.

Die laufzeitgesteuerte Verzögerungsleitung kann z. B. eine nichtgetaktete Kette aus Invertern, Invertergruppen oder sonstigen laufzeitbehafteten Signalübertragungsstufen sein mit Spannungsabgriffen an allen Verbindungsstellen jeweils zweier benachbarter Kettenglieder. Mittels der einstellbaren Schaltverzögerung der Kettenglieder wird die Gesamtlaufzeit entweder mit der Referenzperiode oder mit der VCO-Periode synchronisiert. Die Synchronisierung kann auch vorteilhafterweise hier entfallen, wenn die laufzeitgesteuerte Verzögerungsleitung in der Art eines Ringoszillators als VCO vo verwendet wird.

Eine besonders vorteilhafte Ausführungsform der als Ring geschalteten laufzeitgesteuerten Verzögerungsleitung ist als Blockschaltbild in Fig. 3 dargestellt. Die Kettenglieder bestehen jeweils aus zwei seriengeschalteten Invertern, sogenannten Doppelinvertern i. Durch die Rückführung der fünf Signalabgriffe 5 ... 9 über das NAND-Gatter nd auf den Eingang der Doppelinverterkette, stellt sich bei beliebigem Eingangszustand nach wenigen Durchläufen ein umlaufendes stabiles Signalbild an den Signalabgriffen 0 bis 15 ein. Ein Block von 11 High-Pegel-Zuständen und ein Block von 5 Low-Pegel-Zuständen läuft zyklisch an den Signalabgriffen 0 bis 15 um. Die Zyklus zeit ist mittels der Schaltverzögerung der Doppelinverter i zu steuern.

Einige Zahlenbeispiele sollen der weiteren Verdeutlichung dienen. Wenn der Akkumulator ac als 24-stufiger Binärzähler ausgebildet ist und mit einer Taktfrequenz von $2^{24}$ Hz (ungefähr 17 MHz) getaktet wird, dann ist er mit dem Eingangszahlenwert d = 1 in einer Sekunde voll; die Zyklusfrequenz des Akkumulators ac beträgt somit 1 Hz. Mit dem Zahlenwert d = 2 erhöht sich die Zyklusfrequenz auf 2 Hz und mit dem Zahlenwert $d = 2^{22}$ auf $2^{22}$ Hz = 4,199804 MHz. Diese Zyklusfrequenzen sind zugleich die Frequenzen des Signals fs oder des Referenzsignals fr, und zwar mit der Genauigkeit von 1 Hz.

Es ist nicht erforderlich, daß alle 24 Stellen des Akkumulators ac dem digitalen Phasenvergleicher dp zugeführt sind, insbesondere wenn die Referenzphase rp oder die VCO-Phase, das Datensignal vp, nur an 16 Spannungsabgriffen abgenommen wird. Dann reichen schon die vier höchstwertigen Stellen des Akkumulators ac für den Phasenvergleich aus. Die digitale Unsicherheit im Phasenvergleich beträgt dann ± 1/32, bezogen auf eine Periode; dies wirkt sich jedoch, durch den nachgeschalteten Tiefpaß geglättet, nicht mehr auf das Signal fs aus.

Die Zyklusfrequenz des Akkumulators ac und die damit zu vergleichende Frequenz des Referenzoszillators ro oder des VCO vo sind somit identisch. Damit können beide Frequenzen gegenüber herkömmlichen Frequenzsynthesesystemen dichter beieinander liegen, was ein Vorteil ist, denn die Synchronisierung des Signals fs erfolgt in entsprechend dicht beieinanderliegenden Zeitabschnitten. Die Freilaufabschnitte, in denen die Phasen auseinanderlaufen können, betragen nur noch einige Perioden, werden also sehr klein.

Als ein weiterer Vorteil kann, die Abstufung der Signalfrequenz sehr fein im Vergleich zur Signalfrequenz selbst sein; im angegebenen Beispiel ist dies 1 Hz, bezogen auf eine Signalfrequenz von 16,8 MHz; dabei beträgt der Frequenzaussteuerbereich mindestens ± 30 % der Signalfrequenz. Da bei der Frequenzsynthese die Referenzoszillatoren im allgemeinen als stabile Festquarzoszillatoren ausgeführt sind, ist die Absolutfrequenz des Signals fs quarzgenau.

Ein weiterer Vorteil ist es, daß nach den beiden Erfindungsvarianten entweder die VCO-Frequenz oder die Referenzfrequenz die niedrigere Frequenz sein kann, wobei durch die Hinzufügung eines Frequenzteilers in den Ausgang des VCO oder des Referenzoszillators je nach Erfindungsvariante beide Frequenzen weiter angenähert werden können.

Ein ganz besonderer Vorteil ist die einfache Integrierbarkeit der erfindungsgemäßen Frequenzsyntheseschaltung, die ihren Einsatz in konsumorientierten Schaltungen ermöglicht, z. B. als Taktgenerator für Farbfernsehempfänger mit digitaler Signalverarbeitung. Hierbei dient die Frequenzsyntheseschaltung zur Erzeugung eines quarzstabilen Taktsignals mit der vierfachen Farbhilfsträgerfrequenz, das mit der Frequenz und Phase des empfangenen Farbsynchronbursts synchronisiert ist. Eine einzige Frequenzsyntheseschaltung ist sogar für den Mehrnormbetrieb mit PAL-, NTSC- oder SECAM-Farbhilfsträgerfrequenz ausreichend und ersetzt die bisher je nach Norm verwendeten ziehbaren und damit empfindlichen Quarzoszillatorschaltungen auf besonders vorteilhafte Weise.

## Patentansprüche

1. Frequenzsyntheseschaltung zur Erzeugung eines analogen Signals (fs) mit digital in Stufen einstellbarer Frequenz, bei der ein ein Referenzsignal (fr) erzeugender Referenzoszillator (ro), ein Phasenvergleicher (dp), ein analoger Tiefpaß (tp) und ein spannungsgesteuerter Oszillator (vo) (= VCO) in dieser Reihenfolge signalflußmäßig in Serie geschaltet sind und bei der der Phasenvergleicher (dp) vom VCO (vo) angesteuert ist, wobei
- der Phasenvergleicher (dp) eine Digitalschaltung ist, deren zweitem Eingang vom VCO (vo) abgeleitete Digitalsignale zugeführt sind und deren Ausgangssignal digital ist,
- das Referenzsignal (fr) am jeweiligen Takteingang des Phasenvergleichers (dp) und eines digitalen Akkumulators (ac) liegt, dessen Ausgang mit dem ersten Eingang des Phasenvergleichers (dp) verbunden ist,
- ein die Frequenz des Signals (fs) bestimmender Zahlenwert (d) dem Eingang des Akkumulators (ac) zugeführt ist und
- der VCO (vo) zusätzlich zum analogen Signal (fs) ein dessen Phase repräsentierendes Datensignal (vp), das dem zweiten Eingang des Phasenvergleichers (dp) zugeführt ist, abgibt, gekennzeichnet durch folgende Merkmale:
- der VCO (vo) enthält einen steuerbaren Verzögerer mit zeitlich äquidistanten Abgriffen oder eine laufzeitgesteuerte Verzögerungsleitung, deren Verzögerungsglieder mindestens teilweise mit Signalabgriffen versehen sind, wobei das am steuerbaren Verzögerer oder an der laufzeitgesteuerten Verzögerungsleitung abgegriffene Digitalsignal, das die Phase repräsentierenden Datensignal (vp) ist, und
- die Gesamtverzögerung des steuerbaren Vezögerers ist mittels eines Steuersignals direkt der Periodendauer des VCO (vo) nachgeführt oder stellt selbst die einstellbare Periodendauer der Schwingung des VCO (vo) dar.

2. Frequenzsyntheseschaltung zur Erzeugung eines analogen Signals (fs) mit digital in Stufen einstellbarer Frequenz, bei der ein ein Referenzsignal (fr) erzeugender Referenzoszillator (ro), ein Phasenvergleicher (dp), ein analoger Tiefpaß (tp) und ein spannungsgesteuerter Oszillator (vo) (= VCO) in dieser Reihenfolge signalflußmäßig in Serie geschaltet sind und bei der der VCO (vo) vom Phasenvergleicher (dp) angesteuert ist, wobei
- der Phasenvergleicher (dp) eine Digitalschaltung ist, deren beiden Eingänge Digitalsignale zugeführt sind und deren Ausgangssignal digital ist,
- der Ausgang eines digitalen Akkumulators (ac) mit dem ersten Eingang des Phasenvergleichers (dp) verbunden ist, und
- ein die Frequenz des analogen Signals (fs) bestimmender Zahlenwert (d) dem Eingang des Akkumulators (ac) zugeführt ist, gekennzeichnet durch folgende Merkmale:
- das analoge Signal (fs), liegt am jeweiligen Takteingang des Phasenvergleichers (dp) und des digitalen Akkumulators (ac), und
- der Referenzoszillator (ro) gibt ein die Phase des Referenzsignals (fr) repräsentierendes Datensignal, die Referenzphase (rp), ab, das dem zweiten Eingang des Phasenvergleichers (dp) zugeführt ist.

3. Frequenzsyntheseschaltung nach Anspruch 2, dadurch gekennzeichnet, daß der Referenzoszillator (ro) einen steuerbaren Verzögerer mit zeitlich äquidistanten Abgriffen oder eine laufzeitgesteuerte Verzögerungsleitung enthält, deren Verzögerungsglieder mindestens teilweise mit Signalabgriffen versehen sind, wobei die am steuerbaren Verzögerer oder an der laufzeitgesteuerten Verzögerungsleitung abgegriffenen Signale die jeweilige Referenzphase (rp) bilden.

4. Frequenzsyntheseschaltung nach Anspruch 1 oder 3, dadurch gekennzeichnet, daß die Verzögerungsleitung zu einem Ring geschaltet ist.

5. Frequenzsyntheseschaltung nach Anspruch 1, dadurch gekennzeichnet, daß der steuerbare Verzögerer oder die laufzeitgesteuerte Verzögerungsleitung Teil eines Regelkreises ist, der die Gesamtverzögerung der einzeln abgegriffenen Signale auf die Periodendauer des Signals (fs) regelt.

6. Frequenzsyntheseschaltung nach Anspruch 3, dadurch gekennzeichnet, daß die steuerbare Verzögerungseinrichtung oder laufzeitgesteuerte Verzögerungsleitung Teil eines Regelkreises ist, der die Gesamtverzögerung der einzeln abgegriffenen Signale auf die Periodendauer des Referenzsignals (fr) regelt.

7. Frequenzsyntheseschaltung nach einem der Ansprüche 1 bis 6, dadurch gekennzeichnet, daß vom Ausgangssignal des Akkumulators (ac) nur höchstwertige Stellen dem Phasenvergleicher (dp) zugeführt sind.

8. Frequenzsyntheseschaltung nach einem der Ansprüche 1 bis 7, dadurch gekennzeichnet, daß die Abgriffe des Verzögerers oder der Verzögerungsleitung parallel dem Phasenvergleicher (dp) zugeführt sind und die Anzahl dieser parallelen Leitungen gleich der Anzahl der durch die höchstwertigen Stellen des Akkumulators (ac) gegebenen Signalzustände ist.

9. Frequenzsyntheseschaltung nach einem der Ansprüche 4 bis 8, gekennzeichnet durch folgende Merkmale:
- die als Ring geschaltete laufzeitgesteuerte Verzögerungsleitung ist ein Ringoszillator,
- mit 15 in Reihe geschalteten nichtgetakteten Doppelinvertern (i) deren Schaltverzögerung einstellbar ist,
- mit einem jeweils zwischen zwei benachbarten Doppelinvertern (i), sowie am Eingang des ersten und am Ausgang des letzten anschlossenen Abgriffen und
- mit einem NAND-Gatter (nd) mit fünf Eingängen, das eingangsseitig mit dem jeweiligen ausgangsseitigen Abgriff (5 ... 9) des fünften bis neunten der Doppelinverter (i) verbunden ist und dessen Ausgang den Eingang des ersten der Doppelinverter (i) speist,
- wobei die Signalverläufe an den 16 Spannungsabgriffen die Steuersignale für die 16 parallelen leitungen des Datensignals (vp) oder der Referenzphase (rp) sind.

## Claims

1. Frequency synthesizer circuit for generating an analog signal (fs) of digitally step-adjustable frequency wherein a reference oscillator (ro) generating a reference signal (fr), a phase comparator (dp), an analog low-pass filter (tp), and a voltage-controlled oscillator (vo) (= VCO) are cascaded in this order, and wherein the phase comparator (dp) is controlled by the VCO (vo), with
- the phase comparator (dp) being a digital circuit whose second input is fed with digital signals derived by the VCO (vo), and whose output signal is digital,
- the reference signal (fr) being applied to the clock inputs of the phase comparator (dp) and a digital accumulator (ac) having its output connected to the first input of the phase comparator (dp),
- the input of the accumulator (ac) being fed with a numerical value (d) determining the frequency of the analog signal (fs), and
- the VCO (vo), in addition to providing the analog signal (fs), delivering a data signal (vp) which is representative of the phase of the analog signal (fs) and is applied to the second input of the phase comparator (dp),
characterized by the following features:
- the VCO (vo) contains a variable delay device with temporally equidistant taps or a variable delay line whose delay elements are provided, at least in part, with taps, the digital signal tapped from the variable delay device or from the variable delay line being the data signal (vp) which is representative of the phase of the analog signal (fs), and
- the total delay of the variable delay device is made to directly track the period of the VCO (vo) by means of a control signal or represents the adjustable period of the oscillations produced by the VCO (vo).

2. Frequency synthesizer circuit for generating an analog signal (fs) of digitally step-adjustable frequency wherein a reference oscillator (ro) generating a reference signal (fr), a phase comparator (dp), an analog low-pass filter (tp), and a voltage-controlled oscillator (vo) (= VCO) are cascaded in this order, and wherein the phase comparator (dp) is controlled by the VCO (vo), with:
- the phase comparator (dp) being a digital circuit whose two inputs are fed with digital signals, and whose output signal is digital,
- the output of a digital accumulator (ac) connected to the first input of the phase comparator (dp), and
- the input of the accumulator (ac) being fed with a numerical value (d) which determines the frequency of the analog signal (fs),
characterized by the following features:
- the analog signal (fs) is applied to the clock inputs of the phase comparator (tp) and the digital accumulator (ac), and
- the reference oscillator (ro) provides a data signal, the reference phase (rp), which is representative of the phase of the reference signal (fr) and is applied to the second input of the phase comparator (dp).

3. A frequency synthesizer circuit as claimed in claim 2, characterized in that the reference oscillator (ro) contains a variable delay device with temporally equidistant taps or a variable delay line whose delay elements are provided, at least in part, with taps, the signals tapped from the variable delay device or the variable delay line forming the respective reference phase (rp).

4. A frequency synthesizer circuit as claimed in claim 1 or 3, characterized in that the delay line is connected to form a ring.

5. A frequency synthesizer circuit as claimed in claim 1, characterized in that the variable delay device or the variable delay line forms part of an automatic control system which regulates the total delay of the individually tapped signals at the period of the analog signal (fs).

6. A frequency synthesizer circuit as claimed in claim 3, characterized in that the variable delay device or the variable delay line forms part of an automatic control system which regulates the total delay of the individually tapped signals at the period of the reference signal (fr).

7. A frequency synthesizer circuit as claimed in any one of claims 1 to 6, characterized in that of the output of the accumulator (ac), only most significant bits are fed to the phase comparator (dp).

8. A frequency synthesizer circuit as claimed in any one of claims 1 to 7, characterized in that the taps of the delay device or of the delay line are connected to the phase comparator (dp) in parallel, and that the number of these parallel lines is equal to the number of signal states determined by the most significant bits of the accumulator (ac).

9. A frequency synthesizer circuit as claimed in any one of claims 4 to 8, characterized by the following features:
- The variable delay line connected to form a ring is a ring oscillator
- with 15 cascaded nonclocked dual inverters (i) whose switching delay is adjustable,
- with taps each connected between two adjacent dual inverters (i) and to the input of the first and the output of the last dual inverter, and
- with a five-input NAND gate (nd) which has its inputs connected to the taps (5 ... 9) at the outputs of the fifth to the ninth of the dual inverters (i), and whose output feeds the input of the first of the dual inverters (i),
- the signals at the 16 voltage taps being the control signals for the 16 parallel lines for the data signal (vp) or the reference phase (rp).

## Revendications

1. Circuit de synthèse de fréquence servant à produire un signal analogique (fs) possédant une fréquence réglable numériquement par échelons, et dans lequel un oscillateur de référence (ro) produisant un signal de référence (fr), un comparateur de phase (dp), un filtre passe-bas analogique (tp) et un oscillateur (vo) commandé par la tension (= VCO) sont branchés en série dans la direction du flux de circulation du signal, dans cet ordre, et dans lequel le comparateur de phase (dp) est commandé par le VCO (vo), et dans lequel:
- le comparateur de phase (dp) est un circuit numérique, à la seconde entrée de laquelle sont envoyés des signaux numériques dérivés du VCO (vo) et dont le signal de sortie est numérique,
- le signal de référence (fr) est appliqué aux entrées respectives de cadence du comparateur de phase (dp) et d'un accumulateur numérique (ac), dont la sortie est reliée à la première entrée du comparateur de phase (dp),
- une valeur chiffrée (d) déterminant la fréquence du signal (fs) est envoyée à l'entrée de l'accumulateur (ac), et
- le VCO (vo) délivre, en plus du signal analogique (fs), un signal de données (vp), qui représente la phase de ce signal et est envoyé à la seconde entrée du comparateur de phase (dp),
   caractérisé par les caractéristiques suivantes:
- le VCO (vo) contient un dispositif de retardement commandable comportant des prises équidistantes dans le temps ou bien une ligne à retard, dans laquelle le temps de transit est commandé et dont les éléments de retardement comportent au moins en partie des prises pour les signaux, le signal numérique prélevé sur le dispositif de retardement commandable ou sur la ligne à retard, dans laquelle le temps de propagation est commandé, étant le signal de données (vp) représentant la phase, et
- le retard global produit par le dispositif de retardement commandable est asservi directement à la durée de la période du VCO (vo), au moyen d'un signal de commande, ou bien représente lui-même la durée réglable de la période de l'oscillation du VCO (vo).

2. Circuit de synthèse de fréquence servant à produire un signal analogique (fs) possédant une fréquence réglable numériquement par échelons, et dans lequel un oscillateur de référence (ro) produisant un signal de référence (fr), un comparateur de phase (dp), un filtre passe-bas analogique (tp) et un oscillateur (vo) commandé par la tension (= VCO) sont branchés en série dans la direction du flux de circulation du signal, dans cet ordre, et dans lequel le VCO (vo) est commandé par le comparateur de phase (dp), et dans lequel:
- le comparateur de phase (dp) est un circuit numérique, aux deux entrées duquel sont envoyés des signaux numériques et dont le signal de sortie est numérique,
- la sortie d'un accumulateur numérique (ac) est reliée à la première entrée du comparateur de phase (dp), et
- une valeur chiffrée (d) déterminant la fréquence du signal analogique (fs) est envoyée à l'entrée de l'accumulateur (ac),
   caractérisé par les caractéristiques suivantes:
- le signal analogique (fs) est appliqué aux entrées respectives de cadence du comparateur de phase (dp) et de l'accumulateur numérique (ac), et
- l'oscillateur de référence (ro) délivre un signal de données qui représente la phase du signal de référence (fr), à savoir la phase de référence (rp), qui est envoyé à la seconde entrée du comparateur de phase (dp).

3. Circuit de synthèse de fréquence selon la revendication 2, caractérisé en ce que l'oscillateur de référence (ro) contient un dispositif de retardement commandable comportant des prises équidistantes dans le temps ou une ligne à retard, dans laquelle le temps de transit est commandé et dont les éléments de retardement sont équipés au moins en partie de prises de prélèvement de signaux, les signaux prélevés sur le dispositif de retardement commandable ou sur la ligne à retard, dans laquelle le temps de transit est commandé, formant la phase de référence respective (rp).

4. Circuit de synthèse de fréquence selon la revendication 1 ou 3, caractérisé en ce que la ligne à retard est branchée de manière à former un anneau.

5. Circuit de synthèse de fréquence selon la revendication 1, caractérisé en ce que le dispositif de retardement commandable ou la ligne à retard, dans laquelle le temps de transit est commandé, fait partie d'un circuit de réglage, qui règle le retard global des signaux prélevés individuellement, sur la durée de la période du signal (fs).

6. Circuit de synthèse de fréquence selon la revendication 3, caractérisé en ce que le dispositif de retardement commandable ou la ligne à retard, dans laquelle le temps de transit est commandé, fait partie d'un circuit de réglage qui règle le temps de retard global des signaux prélevés individuellement, sur la durée de la période du signal de référence (fr).

7. Circuit de synthèse de fréquence selon l'une des revendications 1 à 6, caractérisé en ce que seuls des bits de poids maximum du signal de sortie de l'accumulateur (ac) sont envoyés au comparateur de phase (dp).

8. Circuit de synthèse de fréquence selon l'une des revendications 1 à 7, caractérisé en ce que les prises du dispositif de retardement ou de la ligne à retard sont raccordées en parallèle au comparateur de phase (dp) et que le nombre de ces lignes parallèles est égal au nombre des états de signaux, fournis par les bits de poids maximum de l'accumulateur (ac).

9. Circuit de synthèse de fréquence selon l'une des revendications 4 à 8, caractérisé par les caractéristiques suivantes:

- la ligne à retard, qui est branchée de manière à former un anneau et dans laquelle le temps de transit est commandé, est un oscillateur en anneau,
- comportant 15 inverseurs doubles branchés en série, non commandés de façon cadencée et dans lesquels le retard de commutation est réglable,
- des prises raccordées respectivement entre deux inverseurs doubles voisins ainsi qu'à l'entrée du premier inverseur et la sortie du second inverseur, et
- une porte NON-ET (nd), qui comporte cinq entrées et dont le côté entrée est relié à la prise respective (5...9), raccordée du côté sortie, des cinquième, sixième, septième, huitième et neuvième inverseurs doubles (i) et dont la sortie alimente l'entrée du premier des inverseurs doubles (i),

- les variations des signaux présentes sur les 16 prises de tension constituent les signaux de commande pour les 16 lignes parallèles de transmission du signal de données (vp) ou de la phase de référence (rp).

FIG.1

FIG.2

FIG.3

0 1 2 3 4 5 6 7 8 9 10 11 12 13 14 15

1